# EUROPEAN PATENT APPLICATION

(11) **EP 3 778 080 A1**
(43) Date of publication of application: **17.02.2021**
(21) Application number: 19776224.8
(22) Date of filing: 25.03.2019
(51) Int. Cl.: B23B 27/14, B23B 51/00, B23C 5/16, C23C 14/06

(54) **SURFACE-COATED CUTTING TOOL**

(30) Priority: 27.03.2018 JP 2018059674
(71) Applicant: Mitsubishi Materials Corporation, Tokyo 100-8117 (JP)
(72) Inventor: KINOSHITA Tatsuki, Tokyo 100-8117 (JP); HASHIMOTO Tatsuo, Tokyo 100-8117 (JP); SATO Shun, Tokyo 100-8117 (JP); SUGAWARA Yuto, Tokyo 100-8117 (JP); MAEKAWA Takuya, Tokyo 100-8117 (JP)
(74) Representative: Gille Hrabal
(86) International application number: PCT/JP2019/012475
(87) International publication number: WO 2019/188967

(57) **Abstract**

There is provided a surface-coated cutting tool including: a tool body (11) formed of a tungsten carbide-based cemented carbide; a lower layer (2) and an upper layer (3) provided on the tool body, in which the lower layer (2) is formed of a W layer (4) formed from a surface of the tool body (11) to the inside at a predetermined depth, a metal carbide layer (5) formed directly on the W layer (4), and a metal carbonitride layer (6) formed directly on the metal carbide layer (5), the upper layer (3) has an alternately laminated structure of A layer and B layer, the A layer is formed of (Al, Ti)N layer represented by (AlₓTi₁₋ₓ)N (where x is an atomic ratio and satisfies 0.40 ≤ x ≤ 0.70), and the B layer is formed of (Al, Ti, Cr, Si, Y)N layer represented by (Al_{1-a-b-c-d}TiₐCr_{b}Si_{c}Y_{d})N (where a, b, c, and d are atomic ratios and satisfy 0 ≤ a ≤ 0.40, 0.05 ≤ b ≤ 0.40, 0 ≤ c ≤ 0. 20, and 0.01 ≤ d ≤ 0.10).

## Description

### [Technical Field]

The present invention relates to a surface-coated cutting tool (hereinafter, referred to as a "coated tool") in which a hard coating layer exhibits excellent chipping resistance and wear resistance without occurrence of peeling or the like during high-speed cutting of a Ni-based heat resistant alloy, and excellent cutting performance during long-term use.

Priority is claimed on Japanese Patent Application No. 2018-059674, filed March 27, 2018, the content of which is incorporated herein by reference.

### [Background Art]

Generally, examples of the coated tool include an indexable insert used to be detachably attached to a tip portion of an insert holder in turning work or planning work of a work material such as various types of steel or cast iron, a drill or a miniature drill used in drilling cutting of the work material, an end mill used in face milling, grooving, shoulder work of the work material, and a solid hub or a pinion cutter used in toothed wheel cutting of a tooth form of the work material.

Many proposals have been made in the related art to improve the cutting performance of coated tool.

For example, Patent Document 1 proposes a hard film having excellent wear resistance formed on a surface of a cutting tool for alloy steel and a method for forming such a hard film, in which the hard film having excellent wear resistance is a hard film consisting of MₐCr_{b}Al_{c}Si_{d}BₑY_{f}Z (herein, M is at least one kind of element selected from 4A group elements, 5A group elements, and 6A group elements (excluding Cr) in the periodic table, Z represents any of N, CN, NO, or CNO, and relationships of a + b + c + d + e + f= 1, 0 < a ≤ 0.3, 0.05 ≤ b ≤ 0.4, 0.4 ≤ c ≤ 0.8, 0 ≤ d ≤ 0.2, 0 ≤ e ≤ 0.2, and 0.01 ≤ f ≤ 0.1 (a, b, c, d, e, and f represent atomic ratios of M, Cr, Al, Si, B, and Y, respectively) are satisfied.

In addition, it is disclosed that, Ti can be selected as the M, the c satisfies 0.5 ≤ c ≤ 0.8 and the f satisfies 0.02 ≤ f ≤ 0.1, in a case where the M is Ti, and the hard film can be obtained by alternately laminating compositions different from each other.

Further, it is disclosed that the hard film can be obtained by loading a body into an AIP apparatus, performing cleaning of the body under specific conditions with Ar ions (for example, pressure: 0.6 Pa, voltage: 500 V, time: 5 minutes), and forming a film by a cathode discharge arc ion plating method.

In addition, in order to improve durability of a coated cutting tool used in cutting work of steel or Ni-based heat resistant alloy, Patent Document 2 proposes a coated cutting tool including a base material, an intermediate film provided on the base material, and a hard film provided on the intermediate film, in which, a nano-beam diffraction pattern is indexed to a WC crystal, the intermediate film is formed of a carbide containing W and Ti and has a film thickness of 1 nm to 10 nm, the hard film is a nitride or a carbonitride having a crystal structure of a face-centered cubic lattice structure and contains at least Al, Ti and Y, and an Al amount (atom%) is 60% to 75%, a Ti amount (atom%) is 20% to 35%, and a Y amount (atom%) is 1% to 5%, in a case where a total of amounts (atom%) of metal elements including semimetal is set to 100%.

Then, in order to form the intermediate film described above, it is preferable to carry out Ti bombardment by using a cathode having a magnetic field configuration in which a coil magnet is provided on an outer periphery of a target to confine an arc spot inside the target. In addition, as specific processing conditions thereof, it is preferable that a negative bias voltage applied to the base material is set to -1000 V to -700 V, a current applied to the target is set to 80 A to 150 A, a heating temperature of the base material before the bombardment process is set to 450° or higher, the Ti bombardment process is performed for 3 minutes to 7 minutes. The Ti bombardment may be carried out while introducing argon gas, nitrogen gas, hydrogen gas, hydrocarbon gas, or the like, and is preferably carried out in a furnace atmosphere under a vacuum of 1.0 × 10⁻² Pa or less.

In addition, Patent Document 3 proposes a coated tool having WC-based cemented carbide as a base material and a manufacturing method therefor, in order to improve adhesion strength between the film and the base material and improve peeling resistance and wear resistance of alloy tool steel (SKD11) in the cutting.

According to Patent Document 3, this coated tool has a W-modified phase (preferably having an average thickness of 10 to 300 nm) having a bcc crystal structure on the surface of the WC-based cemented carbide base material, the W-modified phase is W formed through decomposition of the WC of the base material into W and C by ion irradiation of one or more metals selected from Ti, Zr, Hf, Nb, and Ta, a carbide phase of one metal selected from Ti, Zr, Hf, Nb, and Ta is provided directly on the W-modified phase, and a hard film is formed directly on the carbide phase (this hard film is preferably at least one layer of a nitride containing Al and one or more elements selected from Ti, Cr, W, Nb, Y, Ce, Si, and B).

It is disclosed that, this coated tool can be manufactured by a first step of performing an ion bombardment process on a base material, and a second step of forming a hard film. The first step of performing the ion bombardment process includes applying a negative bias voltage of -1000 to -600 (V) to a base material, evaporating a cathode substance (one or more metals selected from Ti, Zr, Hf, Nb, and Ta) from an arc discharge evaporation source using a mixed gas of hydrogen gas and Ar or N₂ (here, a volume percentage of the hydrogen gas in the mixed gas is 1 % to 20%) at a pressure of 0.01 to 2 Pa, irradiating the base material with the metal ions evaporated from the cathode substance, so as to form a carbide phase of one or more metals selected from Ti, Zr, Hf, Nb, and Ta directly on the W-modified phase while forming a W-modified phase having a bcc structure in the crystal structure on the surface of the base material by setting a surface temperature of the base material in a range of 800°C to 860°C, and to form a hard film directly on the carbide phase.

### [Citation List]

### [Patent Literature]

[Patent Document 1] Japanese Patent No. 4713413
[Patent Document 2] Japanese Unexamined Patent Application, First Publication No. 2017-001147
[Patent Document 3] Japanese Patent No. 5098726

### [Summary of Invention]

### [Technical Problem]

In recent years, FA of machine tools has been remarkably changed, but on the other hand, there is a strong demand for labor saving, energy saving, and cost reduction for cutting, and along with this, cutting tends to become even faster and more efficient. At the same time, there is a tendency to require a general-purpose cutting tool that enables cutting of work materials of as many kinds as possible.

In the coated tools of the related art shown in Patent Documents 1 and 3, in a case where this is used for cutting of alloy steel, no particular problem arises, but in a case where this is applied to high-speed milling and high-speed drilling of Ni-based heat resistant alloy represented by Inconel 718 (registered trademark), for example, the adhesion between a tool body and the hard coating layer is not sufficient, while great thermal loads and mechanical loads are exerted to a cutting edge. As a result, abnormal damage such as peeling occurs, and due to this, the service life is reached in a short time.

In addition, in Patent Document 2, a nitride layer or carbonitride layer having a cubic crystal structure containing at least Al, Ti, and Y is provided as a hard film, and an intermediate film formed is provided between a tool body and the hard film by Ti bombardment process to increase durability of the coated tool in cutting of Ni-based heat resistant alloy or the like. However, in the cutting such as the high-speed milling and the high-speed drilling of the Ni-based heat resistant alloy in which great thermal loads and mechanical loads are exerted to the cutting edge, the adhesion between the intermediate film and the hard film is not sufficient. Therefore, peeling is likely to occur, and due to this, the service life is reached in a relatively short time as it is.

### [Solution to Problem]

Therefore, from the above-mentioned viewpoints, the inventors of the present invention have conducted intensive studies to develop a coated tool in which a hard coating layer has excellent adhesion resistance, chipping resistance, fracture resistance, and peeling resistance under the cutting work conditions of high-speed milling and high-speed drilling of Ni-based heat resistant alloy, in which high-temperature heat is generated and great thermal loads and mechanical loads are exerted to a cutting edge, and excellent wear resistance is exhibited during long-term use, and have found the followings.

The inventors of the present invention first have investigated applicability of the hard film disclosed in Patent Document 1 proposed as a cutting tool for alloy steel as a cutting tool of Ni-based heat resistant alloy. It is found that, in a case of being represented by a composition formula: (Al_{1-a-b-c-d}TiₐCr_{b}Si_{c}Y_{d})N, a coated tool including a hard coating layer (hereinafter, may be referred to as a "(Al, Ti, Cr, Si, Y)N layer") having an average composition satisfying 0 ≤ a ≤ 0.40, 0.05 ≤ b ≤ 0.40, 0 ≤ c ≤ 0.20, and 0.01 ≤ d ≤ 0.10 (where a, b, c and d are all atomic ratios) is suitable from a viewpoint of adhesion resistance in high-speed cutting of a Ni-based heat resistant alloy.

That is, in the above coated tool, in particular, the Y component contained in the hard coating layer generates a stable oxide on the outermost surface of the hard coating layer, and this oxide improves the adhesion resistance, and, the Y component is uniformly present in the hard coating layer. Accordingly, the oxide of Y is constantly present on the outermost surface of the hard coating layer, even in a case where the cutting is proceeded, and the adhesion resistance does not deteriorate.

However, in a case where a layer thickness of the (Al, Ti, Cr, Si, Y)N layer is excessively increased, chipping, fracture, peeling, and the like occur, which shortens the life of the coated tool.

Therefore, the inventors of the present invention have provided a hard coating layer with a structure in which the above-mentioned (Al, Ti, Cr, Si, Y)N layer and a composite nitride layer of Al and Ti (hereinafter, may referred to as a "(Al, Ti)N layer") are alternately laminated, in order to provide a coated tool exhibiting excellent wear resistance during long-term use without occurrence of chipping, fracture, peeling, and the like. In addition, the surface of the tool body is subjected to a bombardment process disclosed in Patent Documents 2 and 3, and then a hard coating layer having the above-mentioned alternately laminated structure was formed. The occurrence of chipping and fracture is prevented during the high-speed cutting of a Ni-based heat resistant alloy, and the life of the tool was extended to some extent. However, the occurrence of peeling cannot be suppressed, and it cannot be said that sufficiently satisfied tool properties are obtained yet.

The inventors of the present invention have further studied about the bombardment process shown in Patent Documents 2 and 3, and have found that, an effect of improving adhesion between the hard coating layer and the tool body can be improved in stepwise, by changing the metal ion bombardment process conditions, forming a lower layer having a layer structure different from that disclosed in Patent Documents 2 and 3, and forming a hard coating layer via the lower layer. In addition, as a result, in high-speed cutting of Ni-based heat resistant alloy, the occurrence of peeling can be suppressed, and at the same time, the occurrence of abnormal damage such as adhesion, chipping, and fracture can be suppressed. Accordingly, it is found that a coated tool having excellent wear resistance during long-term use can be obtained.

That is, by the inventors of the present invention, in a case of carrying out ion bombardment of any one metal selected from Ti, Cr, Zr, Hf, Nb, and Ta as the metal ion bombardment with respect to the tool body, the process atmosphere thereof is set to high vacuum state of 1 × 10⁻³ Pa or higher, a process temperature of the tool body is increased to approximately 750°C to 800°C, and the process time is increased (for example, 30 minutes to 60 minutes). As a result, it is found that, by forming the lower layer different from the lower layers disclosed in Patent Documents 2 and 3, specifically, a lower layer formed of a W layer (tungsten layer), a metal carbide layer formed directly on the layer, and a metal carbonitride layer formed directly on the metal carbide layer, adhesion between the hard coating layer and the tool body can be increased.

It is found that, by forming such a lower layer between the hard coating layer and the tool body, a coated tool in which occurrence of peeling is prevented and abnormal damage such as adhesion, chipping, and fracture is prevented, during the high-speed cutting of a Ni-based heat resistant alloy in which the high-temperature heat is generated and great thermal loads and mechanical loads are exerted to a cutting edge, and excellent cutting performance is exhibited during long-term use, is obtained.

The present invention has been made based on the above findings, and a surface-coated cutting tool according to the present invention has the following configurations (1) to (3).
(1) A surface-coated cutting tool including: a tool body formed of a tungsten carbide-based cemented carbide; a lower layer provided on the tool body; and an upper layer provided on a surface of the lower layer and having an alternately laminated structure, and having configurations (a) to (g).
   (a) The lower layer consists of a W layer, a metal carbide layer, and a metal carbonitride layer.
   (b) The W layer is formed from a surface of the tool body to an inside thereof over a depth of 10 to 500 nm.
   (c) The metal carbide layer, a metal of which is any one selected from Ti, Cr, Zr, Hf, Nb, and Ta, has an average layer thickness of 5 to 500 nm, and is formed directly on the W layer.
   (d) The metal carbonitride layer includes a metal component contained in the metal carbide layer, has an average layer thickness of 5 to 300 nm, and is formed directly on the metal carbide layer.
   (e) The upper layer has an alternately laminated structure in which at least one A layer and at least one B layer are alternately laminated and has an average total layer thickness of 1.0 to 8.0 µm.
   (f) The A layer is a composite nitride layer of Al and Ti having a one-layer average layer thickness of 0.1 to 5.0 µm, and has an average composition satisfying 0.40 ≤ x ≤ 0.70 (where x is an atomic ratio), in a case where a composition of the composite nitride layer is represented by a composition formula: (AlₓTi₁₋ₓ)N.
   (g) The B layer is a composite nitride layer of Al, Ti, Cr, Si, and Y having a one-layer average layer thickness of 0.1 to 5.0 µm and has an average composition satisfying 0 ≤ a ≤ 0.40, 0.05 ≤ b ≤ 0.40, 0 ≤ c ≤ 0.20, and 0.01 ≤ d ≤ 0.10 (where, all of a, b, c, and d are atomic ratios), in a case where a composition of the composite nitride layer is represented by a composition formula: (Al_{1-a-b-c-d}TiₐCr_{b}Si_{c}Y_{d})N.
(2) The surface-coated cutting tool according to (1), in which the surface-coated cutting tool is any one of a surface-coated insert, a surface-coated end mill, and a surface-coated drill.
(3) A surface-coated cutting tool for high-speed cutting of an Ni-based heat resistant alloy, which is formed of the surface-coated cutting tool according to (1) or (2) described above.

### [Advantageous Effects of Invention]

The coated tool of the present invention includes the lower layer and the upper layer, the lower layer is formed of the W layer formed from the surface of the tool body to the inside thereof at a predetermined depth, a metal carbide layer formed on the surface of the W layer, and the metal carbonitride layer formed on the surface of the metal carbide layer, the upper layer has an alternately laminated structure in which at least the A layer formed of an (Al,Ti)N layer and at least the B layer formed of (Al, Ti, Cr, Si, Y)N layer are laminated, the adhesion strength between the tool body and the upper layer is increased by the lower layer formed between the tool body and the upper layer, and the upper layer has excellent adhesion resistance, chipping resistance, fracture resistance, and wear resistance.

Therefore, the coated tool of the present invention prevents the occurrence of peeling, prevents the occurrence of abnormal damage such as adhesion, chipping, and fracture, during high-speed cutting of a Ni-based heat resistant alloy, in which high-temperature heat is generated and great thermal loads and mechanical loads are exerted to a cutting edge, and exhibits excellent cutting performance during long-term use.

### [Brief Description of Drawings]

Fig. 1 shows an example of a schematic vertical sectional diagram of a coated tool according to an embodiment.
Fig. 2A shows an example of a schematic plan view of an arc ion plating apparatus (a metal target for metal ion bombardment is not shown) used for forming an upper layer of a coated tool according to an embodiment.
Fig. 2B shows an example of a schematic front view of the arc ion plating apparatus (a metal target for metal ion bombardment is not shown) used for forming the upper layer of the coated tool according to an embodiment.

### [Description of Embodiments]

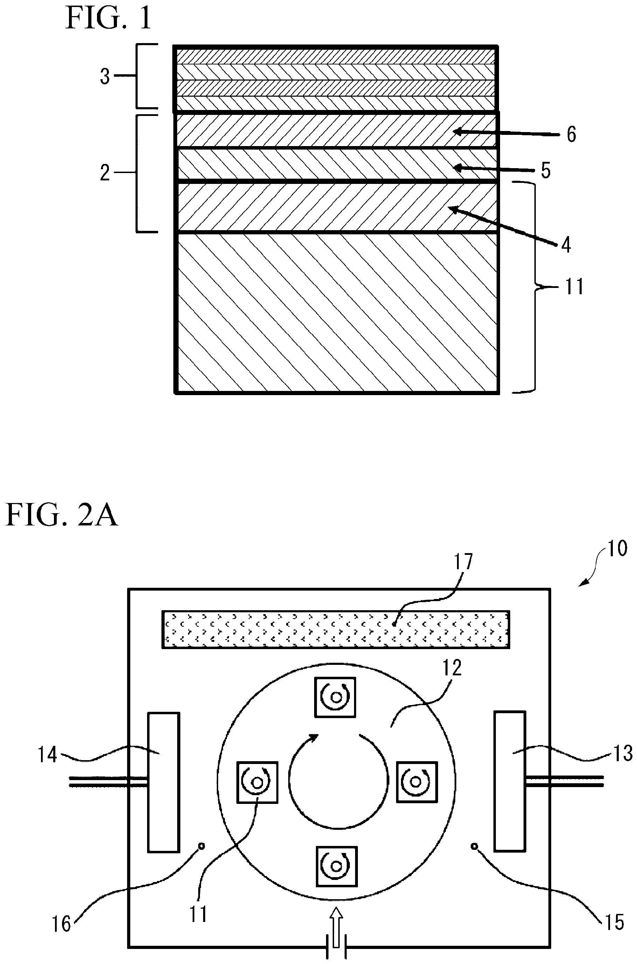

Fig. 1 shows a schematic vertical sectional diagram of a surface-coated cutting tool according to an embodiment.

As shown in Fig. 1, in the coated tool according to this embodiment, a lower layer 2 and an upper layer 3 having an alternately laminated structure are provided on a tool body 11 formed of a tungsten carbide-based cemented carbide.

The lower layer 2 is formed of a W layer 4, a metal carbide layer 5, and a metal carbonitride layer 6, but the W layer 4 is not formed on the surface of the tool body 11, but is formed from a surface of the tool body 11 to the inside thereof at an average depth of 10 to 500 nm.

The metal carbide layer 5 is formed directly on the W layer 4 to have an average layer thickness of 5 to 500 nm, and the metal carbonitride layer 6 is formed directly on the metal carbide layer 5 to have an average layer thickness of 5 to 300 nm. In addition, the upper layer 3 formed of an alternately laminated structure in which at least one A layer and one B layer are alternately laminated and having an average total layer thickness of 1.0 to 8.0 µm is formed on a surface of the lower layer 2 formed of the W layer 4, the metal carbide layer 5, and the metal carbonitride layer 6.

### [Measurement method of average layer thickness]

For the measurement of the layer thickness, a vertical section is cut out using a focused ion beam (FIB), and the cross section measurement is performed using an energy dispersive X-ray spectroscopy (EDS), an auger electron spectroscopy (AES), and an electron probe micro analyzer (EPMA) using a scanning electron microscope (SEM) or a transmission electron microscope (TEM). The method for obtaining the layer thickness of each layer of the upper layer is specifically described as follows. A line analysis of the composition with respect to the normal direction of a body surface is performed with respect to the vertical section of the tool. Based on a component content change curve obtained by doing so, a boundary between the A layer and the B layer is set to an increase start position and a decrease start position of a Cr content in the B layer. Accordingly, the layer thickness of the A layer is obtained based on the decrease start position of the Cr content to the increase start position of the Cr content, and the layer thickness of the B layer is obtained based on the increase start position of the Cr content to the decrease start position of the Cr content. The average layer thickness refers to an average value calculated by performing the above measuring method 5 times.

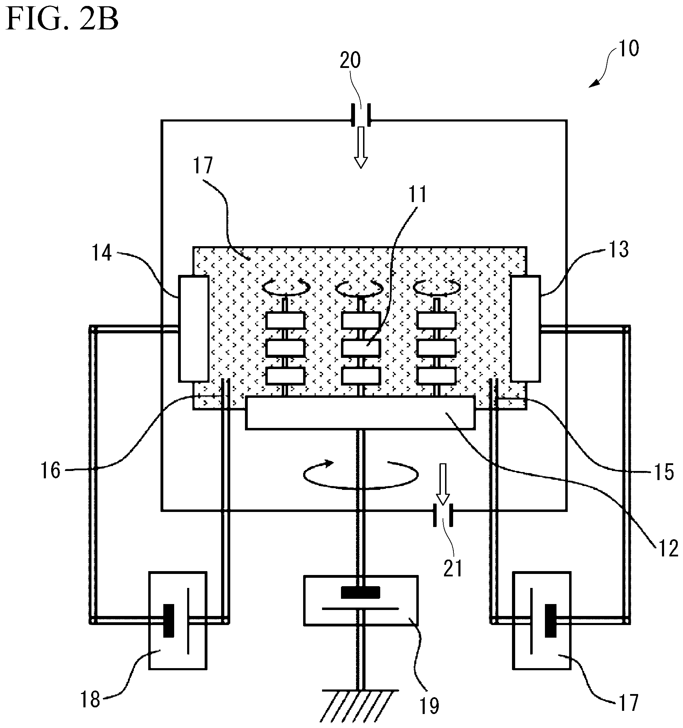

Figs. 2A and 2B show an arc ion plating (hereinafter, referred to as "AIP") apparatus 10 for forming a layer structure of the surface-coated cutting tool according to the present embodiment (A metal target for metal ion bombardment process is not shown). A metal ion bombardment is performed under predetermined conditions with respect to a surface of the tool body 11 disposed on a rotation table of the AIP apparatus 10 to form the lower layer 2 formed of the W layer 4, the metal carbide layer 5, and the metal carbonitride layer 6. After that, the A layer and the B layer are alternately laminated to form the upper layer 3, and a surface-coated cutting tool according to the present embodiment having the layer structure can be manufactured.

### [Lower layer]

The W layer 4 and the metal carbide layer 5 configuring the lower layer 2 are both layers formed by metal ion bombardment process.

Among the layers configuring the lower layer 2, the W layer 4 and the metal carbide layer 5 directly on the W layer 4 are subjected to the metal ion bombardment (irradiation). Accordingly, WC in the vicinity of the surface of the tool body 11 is decomposed into W and C. Accordingly, the W layer 4 is formed from the surface of the tool body 11 to a predetermined depth, and the metal carbide layer 5 is generated on the surface of the W layer 4 due to a reaction between the ion-bombarded metal and C.

Here, in a case where the average thickness (depth) of the W layer 4 to be formed is less than 10 nm, the metal carbide layer 5 directly thereon is not sufficiently formed, and sufficient adhesion strength with a hard layer cannot be obtained. On the other hand, in a case where the average thickness exceeds 500 nm, the hard coating layer is easily peeled off due to the embrittlement of the surface of the tool body 11. Accordingly, the average thickness (depth) of the W layer 4 formed from the surface of the tool body 11 to the inside thereof is set to 10 to 500 nm or less. The average thickness thereof is more preferably 20 nm to 300 nm.

In addition, as described above, the metal carbide layer 5 formed directly on the W layer 4 is formed by the reaction of bombarded metal ions with C obtained by decomposing WC into W and C. In a case where the average layer thickness thereof is less than 5 nm, the thickness of the W layer 4 becomes excessively thin and the effect of improving the adhesion to the hard layer is slight. On the other hand, in a case where the average layer thickness thereof exceeds 500 nm, the average thickness (depth) of the W layer 4 exceeds 500 nm. Accordingly, the surface of the tool body 11 becomes brittle. Therefore, the average layer thickness of the metal carbide layer 5 formed directly on the W layer 4 is set to 5 to 500 nm. The average layer thickness thereof is more preferably 10 nm to 300 nm.

### [Measurement method of average thickness (depth) of W layer]

For the measurement of the thickness (depth) of the W layer, a vertical section is cut out using a focused ion beam (FIB), and the cross section measurement is performed using an energy dispersive X-ray spectroscopy (EDS), an auger electron spectroscopy (AES), and an electron probe micro analyzer (EPMA) using a scanning electron microscope (SEM) or a transmission electron microscope (TEM). The method for obtaining the thickness (depth) of the W layer is specifically described as follows. A line analysis of the composition with respect to the normal direction of a body surface is performed with respect to the vertical section of the tool. The boundary of each layer is defined as follows based on the component content change curve obtained by doing so. First, the boundary between the WC and the W layer is set to the increase start position of the W content. In addition, the boundary between the W layer and the metal carbide layer is an intersection between a curve showing the change in the W content and a curve showing the change in the amount of the metal component forming the metal carbide layer. Accordingly, the thickness (depth) of the W layer is obtained based on the increase start position of the W content, and the intersection between the curve showing the change in the W content and the curve showing the change in the amount of the metal component forming the metal carbide layer. The average thickness of the W layer refers to an average value calculated by performing the above measuring method 5 times.

### [Measurement Method of Average Thickness of Metal Carbide Layer]

For the measurement of the thickness of the metal carbide layer, a vertical section is cut out using a focused ion beam (FIB), and the cross section measurement is performed using an energy dispersive X-ray spectroscopy (EDS), an auger electron spectroscopy (AES), and an electron probe micro analyzer (EPMA) using a scanning electron microscope (SEM) or a transmission electron microscope (TEM). The method for obtaining the thickness of the metal carbide layer is specifically described as follows. A line analysis of the composition with respect to the normal direction of a body surface is performed with respect to the vertical section of the tool. The boundary of each layer is defined as follows based on the component content change curve obtained by doing so. In addition, the boundary between the W layer and the metal carbide layer is an intersection between a curve showing the change in the W content and a curve showing the change in the amount of the metal component forming the metal carbide layer. In addition, a boundary between the metal carbide layer and the metal carbonitride layer is an increase start position of the N content. Accordingly, the thickness of the metal carbide layer is obtained based on the intersection between the curve showing the change in the W content and the curve showing the change in the amount of the metal component forming the metal carbide layer, and the increase start position of the N content. The average thickness of the metal carbide layer refers to an average value calculated by performing the above measuring method 5 times.

### [Measurement Method of Average Thickness of Metal Carbonitride Layer]

For the measurement of the thickness of the metal carbonitride layer, a vertical section is cut out using a focused ion beam (FIB), and the cross section measurement is performed using an energy dispersive X-ray spectroscopy (EDS), an auger electron spectroscopy (AES), and an electron probe micro analyzer (EPMA) using a scanning electron microscope (SEM) or a transmission electron microscope (TEM). The method for obtaining the thickness of the metal carbonitride layer is specifically described as follows. A line analysis of the composition with respect to the normal direction of a body surface is performed with respect to the vertical section of the tool. The boundary of each layer is defined as follows based on the component content change curve obtained by doing so. First, a boundary between the metal carbide layer and the metal carbonitride layer is an increase start position of the N content. In addition, a boundary between the metal carbonitride layer and the upper layer is an intersection between the curve showing the change in the amount of the metal component forming the metal carbonitride layer and the curve showing the change in the amount of the metal component forming the upper layer. Accordingly, the thickness of the metal carbonitride layer is obtained based on the increase start position of the N content, and the intersection between the curve showing the change in the amount of the metal component forming the metal carbonitride layer and the curve showing the change in the amount of the metal component forming the upper layer. The average thickness of the metal carbonitride layer refers to an average value calculated by performing the above measuring method 5 times.

In addition, the metal carbonitride layer 6 is formed on the surface of the metal carbide layer 5, and the metal carbonitride layer 6 is a layer formed in a case where the upper layer 3 is formed by deposition after the metal ion bombardment process. Metal ion bombardment process is performed for a long time (30 to 60 minutes) under high vacuum state to form the W layer 4 and the metal carbide layer 5, and then the upper layer 3 is formed by deposition in a nitrogen atmosphere. Accordingly, the metal carbonitride layer 6 can be formed. By this forming method, the metal carbonitride layer 6 containing the metal component contained in the metal carbide layer 5 is formed.

The metal carbonitride layer 6 has excellent adhesion strength with the metal carbide layer 5, and also has excellent adhesion with a hard layer formed on the surface of the metal carbonitride layer 6, particularly, the A layer formed of a composite nitride layer of Al and Ti. Therefore, the hard layer is prevented from being peeled off during high-speed cutting of the Ni-based heat resistant alloy in which high-temperature heat is generated and great thermal loads and mechanical loads are exerted to the cutting edge. However, in a case where the average layer thickness of the metal carbonitride layer 6 is less than 5 nm, the adhesion between the metal carbide layer 5 and the A layer is not sufficiently exhibited, and in a case where the average layer thickness exceeds 300 nm, strain in the layer increases, which causes a decrease in adhesion. Therefore, the average layer thickness of the metal carbonitride layer 6 is set to 5 to 300 nm. The average layer thickness thereof is more preferably 10 to 200 nm.

### [Formation of lower layer]

More specifically, an example of the method for forming the lower layer 2 is as follows.

First, the tool body 11 is rotatably placed on a rotation table 12 in the AIP apparatus 10, the inner atmosphere of the apparatus is held in a high vacuum state of 1 × 10⁻³ Pa or less, and the temperature of the tool body 11 is increased to approximately 500°C. Then, the temperature of the tool body 11 is increased to approximately 750°C to 800°C, this temperature is held during the metal ion bombardment process, and then a bias voltage of approximately -1000 V is applied to the tool body 11. A target for metal ion bombardment (for example, a Ti target) is supplied with an arc current of approximately 100 A, and this process is continued for approximately 30 to 60 minutes to perform the metal ion bombardment process. The W layer 4 is formed from the surface of the tool body 11 to the inside thereof at a predetermined depth, at the same time, the metal carbide layer 5 having a predetermined thickness is formed on the surface of the W layer 4, and the metal carbonitride layer 6 is formed by a diffusion reaction between the upper layer 3 and the metal carbide layer 5 in a case of forming the upper layer 3 by deposition.

By the method described above, the lower layer 2 formed of the W layer 4 having a predetermined depth, the metal carbide layer 5 having a predetermined average layer thickness, and the metal carbonitride layer 6 having a predetermined average layer thickness can be formed on the tool body 11.

The W layer 4, the metal carbide layer 5, and the metal carbonitride layer 6 are desirably formed in layer shape on the tool body 11, but may be preferentially formed in an island shape on the WC particles, for example. Even in this case, the effect of improving the adhesion strength between the base material and the hard coating layer can be obtained.

As the metal of the metal carbide layer 5, any one metal selected from Ti, Cr, Zr, Hf, Nb, and Ta is preferable, and Ti and Cr are particularly preferable.

In a case where the ion bombardment is performed with respect to the above-mentioned metals forming the metal carbide layer 5, each of the above-mentioned metals is more likely to form a carbide than W. Therefore, the metal reacts with C obtained by decomposition into W and C, in the vicinity of the surface of the tool body 11. As a result, the metal carbide layer 5 is formed on the surface of the W layer 4.

The metal carbonitride layer 6 is a carbonitride layer containing a metal component contained in the metal carbide layer 5, and as the kinds of metals forming the metal carbonitride layer 6, at least one or more metals selected from Al, Ti, Cr, Zr, Hf, Nb, and Ta are preferable, and Ti and Cr are particularly preferable.

Since the metal carbonitride layer 6 is formed, the lattice mismatch at the boundary with the upper layer 3 is alleviated. Accordingly, the adhesion strength with the upper layer 3 is improved.

The ratio of carbon to nitrogen in the metal carbonitride layer 6 is not limited, and the ratio of atomic concentration of nitrogen to a total atomic concentration of carbon and nitrogen is preferably 0.1 to 0.9, and more preferably 0.1 to 0.6, as an average in the metal carbonitride layer 6.

Since the metal forming the metal carbide layer 5 and the metal forming the metal carbonitride layer 6 are the same kind of metal (for example, Ti carbide layer and Ti carbonitride layer), it is advantageous to continuously perform the metal ion bombardment process and the forming process of the metal carbonitride layer.

However, the metals are not limited to the same kind, and different kinds of metals may be used. In the metal ion bombardment process of the present invention, W particles may partially remain in the layer during the reaction process in a case of forming the lower layer 2, but in that case also, the effect of improving the adhesion of the lower layer 2 is exhibited.

### [Upper layer]

The upper layer 3 formed on the lower layer 2 has an alternately laminated structure in which at least one A layer and at least one B layer are alternately laminated, and has an average total layer thickness of 1.0 to 8.0 µm.

The A layer is a composite nitride (hereinafter, may be referred to as a "(Al,Ti)N") layer of Al and Ti having average layer thickness of 0.1 to 5.0 µm per one layer, and has an average composition satisfying 0.40 ≤ x ≤ 0.70 (where x is an atomic ratio), in a case where a composition thereof is represented by a composition formula: (AlₓTi₁₋ₓ)N.

The B layer is a composite nitride ("(Al, Ti, Cr, Si, Y)N") layer of Al, Ti, Cr, Si, and Y having average layer thickness of 0.1 to 5.0 µm per one layer, and has an average composition satisfying 0 ≤ a ≤ 0.40, 0.05 ≤ b ≤ 0.40, 0 ≤ c ≤ 0.20, and 0.01 ≤ d ≤ 0.10 (where, all of a, b, c, and d are atomic ratios), in a case where a composition thereof is represented by a composition formula: (Al_{1-a-b-c-d}TiₐCr_{b}Si_{c}Y_{d})N.

The value of N/(Ti + Al + N) in the composition formula for the A layer and the value of N/((Al + Ti + Cr + Si + Y + N) in the composition formula for the B layer do not necessarily have to be the stoichiometric ratio of 0.5. Excluding elements such as carbon and oxygen which are inevitably detected due to the influence of contamination on the surface of the tool body 11, an atomic ratio of the amounts of Ti, Al and N is quantified, and the atomic ratios of the amounts of Al, Ti, Cr, Si, Y, and N are also quantified. In a case where the value of N/(Ti + Al + N) or the value of N/((Al + Ti + Cr + Si + Y + N) are in a range of 0.45 to 0.65, there is no particular problem, since the effect equivalent to that of the A layer or the B layer having a stoichiometric ratio of 0.5 is obtained.

### [(Al,Ti)N layer forming A layer of upper layer]

In a case where a one-layer average layer thickness of the A layer formed of the (Al,Ti)N layer is less than 0.1 µm, the effect of improving wear resistance and the effect of improving fracture resistance are insufficient. On the other hand, in a case where the average layer thickness per one layer thereof exceeds 5.0 µm, the internal strain of the A layer increases and the A layer easily breaks. Accordingly, the average layer thickness per one layer of the A layer is set to 0.1 to 5.0 µm.

In addition, in the composition formula of the A layer: (AlₓTi₁₋ₓ)N, in a case where a value of x indicating an average composition of Al is less than 0.40, the adhesion strength between the metal carbonitride layer 6 of the lower layer 2 and the A layer and the adhesion strength between the A layer and the B layer increase, whereas high temperature hardness and high temperature oxidation resistance of the A layer decrease. On the other hand, in a case where the value of x exceeds 0.70, crystal grains having a hexagonal crystal structure are likely to be formed, the hardness of the A layer is decreased, and sufficient wear resistance cannot be obtained.

Therefore, the value of x indicating the average composition of Al is set to satisfy 0.40 ≤ x ≤ 0.70.

The value of x indicating the average composition of Al is more preferably set to satisfy 0.50 ≤ x ≤ 0.70.

The average composition x of the Al component in the A layer can be obtained by measuring the amount of the Al component at a plurality of portions (for example, 5 portions) in the vertical section of the A layer using SEM-EDS and averaging the measured values.

The plurality of portions of the vertical section are selected from at least five portions so that a distance between the portions is 100 nm to 200 nm from one randomly selected portion.

### [(Al, Ti, Cr, Si, Y)N layer forming B layer of upper layer]

In the (Al, Ti, Cr, Si, Y)N layer forming the B layer of the upper layer 3, the Al component has an effect of improving high temperature hardness and heat resistance, the Ti component has an effect of improving high temperature hardness, the Cr component has an effect of improving high temperature toughness and high temperature strength and improving high temperature oxidation resistance, in a state where Al and Cr are contained together, the Si component has an effect of improving heat plastic deformation resistance, and the Y component has an effect of increasing adhesion resistance and also oxidation resistance, as described above.

In a case where the a value (atomic ratio), which indicates the amount of Ti in a total amount of Al, Ti, Cr, Si, and Y in the (Al, Ti, Cr, Si, Y)N layer, exceeds 0.40, the durability of the coated tool is decreased due to a relative decrease in the Al content. Accordingly, the value a is set to 0 to 0.40.

In a case where the b value (atomic ratio) showing the amount of Cr in the (Al, Ti, Cr, Si, Y)N layer is less than 0.05, it is not possible to ensure high temperature toughness and high temperature strength which are at least required. Accordingly, it is not possible to prevent occurrence of chipping and fracture. On the other hand, in a case where the b value thereof exceeds 0.40, the progress of wear is promoted due to the relative decrease in the Al content. Accordingly, the b value is determined as 0.05 to 0.40.

In a case where the c value (atomic ratio) indicating the amount of Si in the (Al, Ti, Cr, Si, Y)N layer exceeds 0.20, the improvement in heat plastic deformation resistance is saturated, while the wear resistance improvement effect tends to decrease. Accordingly, the c value is determined as 0 to 0.20.

In a case where the d value (atomic ratio) indicating the amount of Y in the (Al, Ti, Cr, Si, Y)N layer is less than 0.01, the effect of improving the adhesion resistance and the oxidation resistance cannot be expected. On the other hand, in a case where the d value exceeds 0.10, AlN having a hexagonal crystal structure is generated and the hardness of the B layer decreases. Accordingly, the d value is determined as 0.01 to 0.10.

The desirable ranges of a, b, c, and d are 0 ≤ a ≤ 0.30, 0.10 ≤ b ≤ 0.30, 0.05 ≤ c ≤ 0.15, and 0.05 ≤ d ≤ 0.08.

In a case where an average layer thickness per one layer of the B layer formed of the (Al, Ti, Cr, Si, Y)N layer is less than 0.1 µm, it is not possible to exhibit excellent wear resistance during long-term use. On the other hand, in a case where the average layer thickness per one layer exceeds 5.0 µm, chipping and fracture are likely to occur. Accordingly, the average layer thickness per one layer of the B layer formed of the (Al, Ti, Cr, Si, Y)N layer is determined as 0.1 to 5.0 µm. Each of the average compositions a, b, c, and d of the Ti component, the Cr component, the Si component, and the Y component in the B layer can be obtained by measuring each component amount at a plurality of portions (for example, 5 portions) in the vertical section of the B layer using SEM-EDS and averaging the measured values.

### [Average total layer thickness of upper layer]

As described above, the average layer thickness per one layer one-layer average layer thickness of the A layer and the average layer thickness per one layer of the B layer are each set to 0.1 to 5.0 µm, and the average total layer thickness of the upper layer 3 having a laminated structure in which at least one A layer and at least one B layer are alternately laminated, is 1.0 to 8.0 µm. The average layer thickness per one layer of the A layer and the average layer thickness per one layer of the B layer are more preferably 0.5 to 4.0 µm, respectively.

This is because that, in a case where the average total layer thickness of the upper layer 3 is less than 1.0 µm, it is not possible to exhibit excellent wear resistance during long-term use. On the other hand, in a case where the average total layer thickness thereof exceeds 8.0 µm, the upper layer 3 is likely to cause abnormal damage such as chipping, fracture, and peeling.

It is preferable that the A layer and the B layer have a laminated structure in which at least one layer of each is alternately laminated.

In a case where the upper layer 3 is formed on the surface of the lower layer 2, the adhesion strength between the A layer and the metal carbonitride layer 6 of the lower layer 2 is high and the adhesion strength between the A layer and the B layer is also high. Therefore, it is desirable to provide the A layer of the upper layer 3 directly on the metal carbonitride layer 6 of the lower layer 2.

The surface-coated cutting tool is preferably any one of a surface-coated insert, a surface-coated end mill, and a surface-coated drill.

The surface-coated cutting tool is preferably for high-speed cutting of Ni-based heat resistant alloy.

### [Examples]

Hereinafter, the present invention will be described in more detail with reference to examples, but the present invention is not limited thereto.

### <<Example 1>>

As raw material powders, a WC powder, a TiC powder, a VC powder, a TaC powder, an NbC powder, a Cr₃C₂ powder, and a Co powder, all of which had an average grain size of 0.5 to 5 µm, were prepared, and the raw material powders were mixed in blending compositions shown in Table 1. Wax was further added thereto, and the mixture was blended in acetone by a ball mill for 24 hours and was decompressed and dried. Thereafter, the resultant was press-formed into green compacts having predetermined shapes at a pressure of 98 MPa, and the green compacts were sintered in a vacuum at 5 Pa under the condition that the green compacts were held at a predetermined temperature in a range of 1370°C to 1470°C for one hour. After the sintering, a cutting edge portion was subjected to honing, thereby manufacturing tool bodies 11 (insert) 1 to 4 made of WC-based cemented carbide with insert shapes according to ISO CNMG120408.

A lower layer and an upper layer are formed on each of the tool bodies 11 (inserts) 1 to 4 in the following steps to manufacture surface-coated inserts 1 to 8 of the present invention (hereinafter referred to as tools 1 to 8 of the present invention), respectively.

### Step (a):

The tool bodies 11 1 to 4 described above were subjected to ultrasonic cleaning in acetone and were dried. In this state, the tool bodies were mounted along outer circumferential portions on a rotation table in The AIP apparatus 10 shown in Figs. 2A and 2B at positions distant from the center axis thereof by predetermined distances in a radial direction thereof, and the target 13 (cathode electrode) formed of an Al-Ti alloy having a predetermined composition is disposed on one side of the AIP apparatus 10, and a target 14 (cathode electrode) formed of an Al-Ti-Cr-Si-Y alloy having a predetermined composition was disposed on the other side thereof.

### Step (b):

First, while the inside of the apparatus was evacuated and held in a vacuum (1 × 10⁻³ Pa or lower), the tool body 11 that was rotated while being revolved on the rotation table was sequentially heated with a heater to a predetermined temperature (tool body temperature during metal ion bombardment process) shown in Table 2 from approximately 500°C, a bias voltage shown in Table 2 was applied to the tool body 11, the arc current shown in Table 2 flowed between the tool body 11 and the target for metal ion bombardment process (for example, Ti), and the metal ion bombardment was performed with respect to the tool body 11 for a process time shown in Table 2, to form the lower layer 2 shown in Table 4.

### Step (c):

Next, nitrogen gas as a reaction gas was introduced into the apparatus to obtain the nitrogen partial pressure shown in Table 3, the temperature of the tool body 11 that was rotated while being revolved on the rotation table 12 was held in a temperature range shown in Table 3, and a DC bias voltage shown in Table 3 was applied thereto. In addition, arc discharge was generated by allowing a current of 150 A to flow between the Al-Ti alloy target 13 and an anode electrode 15, and the A layer having the composition and the one-layer average layer thickness shown in Table 4 was formed by deposition on the surface of the tool body 11.

### Step (d):

Next, nitrogen gas as a reaction gas was introduced into the apparatus from a reaction gas inlet 20 to obtain the nitrogen partial pressure shown in Table 3, a temperature of the tool body 11 that was rotated while being revolved on the rotation table 12 was held in a temperature range shown in Table 3, and a DC bias voltage shown in Table 3 was applied thereto. In addition, arc discharge was generated by allowing a current of 150 A to flow between the Al-Ti-Cr-Si-Y alloy target 14 and an anode electrode 16, and the B layer having the composition and the one-layer average layer thickness shown in Table 4 was formed by deposition on the surface of the tool body 11.

### Step (e):

Next, the above (c) and (d) were repeated until the average total layer thickness of the upper layer was reached.

The tools 1 to 8 of the present invention shown in Table 4 were manufactured by the steps (a) to (e).

### Comparative example:

For comparison, tool bodies 11 (inserts) 1 to 4 made of WC-based cemented carbide manufactured in Example 1 were subjected to ultrasonic cleaning in acetone and were dried. In this state, the tool bodies were mounted along outer circumferential portions on a rotation table in the AIP apparatus 10 shown in Figs. 2A and 2B at positions distant from the center axis thereof by predetermined distances in a radial direction thereof, and surface-coated inserts 1 to 6 of the comparative examples (hereinafter, comparative example tools 1 to 6) shown in Table 7 were manufactured by the same method as in Example 1, except that the metal ion bombardment process conditions in Example 1 were changed.

Specifically, it is as follows.

Regarding the comparative example tools 1 to 4, as shown in comparative example conditions 1 to 4 in Table 5, while maintaining the inside of the AIP apparatus 10 as the furnace inner atmosphere and the furnace inner pressure shown in Table 5, the tool body 11 was heated by the heater to a temperature shown in Table 5. Then, a DC bias voltage shown in Table 5 was applied to the tool body 11 that was rotated while being revolved on the rotation table 12, the arc discharge was generated by allowing an arc current shown in Table 5 to flow between the target for metal ion bombardment and the anode electrode, thereby performing bombardment process to the surface of the tool body 11.

In addition, for the comparative example tools 5 and 6, the bombardment process as shown in the comparative example conditions 5 and 6 of Table 5 was performed, but the process of the comparative example condition 5 is within the range disclosed in Patent Document 2. In addition, the process of the comparative example condition 6 is within the range disclosed in the Patent Document 3. The film forming conditions of the upper layer after the bombardment process of the comparative example tools 1 to 4 and the comparative example tools 5 and 6 are as shown in Table 6.

For the tools 1 to 8 of the present invention and the comparative example tools 1 to 6 manufactured above, a vertical section was cut out using a focused ion beam (FIB), and the cross section measurement was performed using an energy dispersive X-ray spectroscopy (EDS), an auger electron spectroscopy (AES), and an electron probe micro analyzer (EPMA) using a scanning electron microscope (SEM) or a transmission electron microscope (TEM). Accordingly, each component composition and each layer thickness of the A layer and the B layer of the upper layer were measured at five portions, and an average composition and an average layer thickness were calculated from average values thereof.

For the W layer, the metal carbide layer, and the metal carbonitride layer of the lower layer, each layer was identified and each layer thickness were calculated from the average measurement of the cross section using the same analysis method as that of the upper layer. The method for obtaining the layer thickness of each layer of the lower layer was specifically performed as follows. A line analysis of the composition with respect to the normal direction of a body surface was performed with respect to the vertical section of the tool. The boundary of each layer was defined as follows based on the component content change curve obtained by doing so. First, the boundary between the WC and the W layer was set to the increase start position of the W content. In addition, the boundary between the W layer and the metal carbide layer was an intersection between a curve showing the change in the W content and a curve showing the change in the amount of the metal component forming the metal carbide layer. Furthermore, a boundary between the metal carbide layer and the metal carbonitride layer was an increase start position of the N content. Then, a boundary between the metal carbonitride layer and the upper layer was an intersection between the curve showing the change in the amount of the metal component forming the metal carbonitride layer and the curve showing the change in the amount of the metal component forming the upper layer. From this, the depth of the W layer, the layer thickness of the metal carbide layer, and the layer thickness of the metal carbonitride layer were obtained based on the W content, the increase start position of the N content, or the intersection of each curve.

This measurement was repeated at five portions in the vertical section of the tool, and the average value thereof was used as the average layer thickness of each of the lower layer.

Tables 4 and 7 show the measured and calculated values.

**[Table 1]**

| Tool body type | Blending composition (mass%) | | | | | | |
|---|---|---|---|---|---|---|---|
| | Co | Tic | VC | TaC | NbC | Cr₃C₂ | WC |
| 1 | 5.5 | - | - | - | - | 0.8 | Balance |
| 2 | 8.0 | - | 0.5 | - | - | 0.5 | Balance |
| 3 | 9.7 | 4.2 | - | 5.0 | 2.5 | - | Balance |
| 4 | 12.0 | - | - | - | - | 1.0 | Balance |

**[Table 2]**

| Lower layer formation type | | Tool body symbol | Metal ion bombardment process conditions | | | | | | |
|---|---|---|---|---|---|---|---|---|---|
| | | | Bombardment metal type | Temperature of tool body during bombardment process (°C) | Furnace inner atmosphere | Furnace inner pressure (Pa) | Bias voltage to tool body (V) | Arc current (A) | bombardment process time (min) |
| Conditions of the present invention | 1 | 1 | Ti | 770 | Vacuum atmosphere | 8×10⁻⁴ | -1000 | 100 | 45 |
| | 2 | 2 | Ti | 780 | Vacuum atmosphere | 5×10⁻⁴ | -1000 | 100 | 35 |
| | 3 | 3 | Cr | 750 | Vacuum atmosphere | 1×10⁻³ | -1000 | 100 | 40 |
| | 4 | 4 | Ti | 760 | Vacuum atmosphere | 7×10⁻⁴ | -1000 | 100 | 30 |
| | 5 | 1 | Zr | 800 | Vacuum atmosphere | 1×10⁻⁴ | -1000 | 100 | 60 |
| | 6 | 2 | Nb | 780 | Vacuum atmosphere | 6×10⁻⁴ | -1000 | 100 | 48 |
| | 7 | 3 | Ta | 750 | Vacuum atmosphere | 4×10⁻⁴ | -1000 | 100 | 50 |
| | 8 | 4 | Hf | 790 | Vacuum atmosphere | 2×10⁻⁴ | -1000 | 100 | 55 |

**[Table 3]**

| Type | | Tool body symbol | Lower layer formation type | Formation conditions of A layer | | | Formation conditions of B layer | | |
|---|---|---|---|---|---|---|---|---|---|
| | | | | Temperature of tool body (°C) | Nitrogen partial pressure (Pa) | Bias voltage (-V) | Temperature of tool body (°C) | Nitrogen partial pressure (Pa) | Bias voltage (-V) |
| Conditions of the present invention | 1 | 1 | 1 | 500 | 4.0 | -75 | 500 | 4.0 | -75 |
| | 2 | 2 | 2 | 500 | 6.7 | -50 | 500 | 4.0 | -150 |
| | 3 | 3 | 3 | 500 | 6.7 | -75 | 500 | 6.7 | -100 |
| | 4 | 4 | 4 | 500 | 4.0 | -50 | 500 | 4.0 | -50 |
| | 5 | 1 | 5 | 500 | 4.0 | -30 | 500 | 9.3 | -100 |
| | 6 | 2 | 6 | 500 | 9.3 | -75 | 500 | 6.7 | -150 |
| | 7 | 3 | 7 | 500 | 4.0 | -40 | 500 | 6.7 | -125 |
| | 8 | 4 | 8 | 500 | 6.7 | -50 | 500 | 9.3 | -100 |

**[Table 4]**

| Type | | Condition type of present invention | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tool of present invention | 1 | 1 | 200 | TiC | 120 | (Ai,Ti)(C,N) | 60 | 4.0 | 0.50 | 1.0 | 0.17 | 0.25 | 0.08 | 0.03 | 5.0 |
| | 2 | 2 | 180 | TiC | 140 | Ti(C,N) | 30 | 2.0 | 0.60 | 2.0 | 0.24 | 0.18 | 0.05 | 0.02 | 4.0 |
| | 3 | 3 | 10 | Cr₃C₂ | 6 | Cr(C,N) | 5 | 5.0 | 0.40 | 1.2 | 0.30 | 0.10 | 0.10 | 0.10 | 6.2 |
| | 4 | 4 | 80 | TiC | 60 | Ti(C,N) | 20 | 1.0 | 0.60 | 4.0 | 0.20 | 0.20 | 0.03 | 0.02 | 5.0 |
| | 5 | 5 | 470 | ZrC | 420 | Zr(C,N) | 60 | 0.1 | 0.70 | 0.1 | 0.05 | 0.40 | 0 | 0.04 | 1.0 |
| | 6 | 6 | 340 | NbC | 60 | Nb(C,N) | 240 | 0.3 | 0.40 | 0.3 | 0.40 | 0.05 | 0.15 | 0.05 | 2.4 |
| | 7 | 7 | 300 | TaC | 240 | Ta(C,N) | 50 | 0.2 | 0.60 | 0.3 | 0.10 | 0.23 | 0.20 | 0.01 | 1.5 |
| | 8 | 8 | 380 | HfC | 220 | Hf(C,N) | 120 | 3.0 | 0.50 | 5.0 | 0 | 0.30 | 0.12 | 0.07 | 8.0 |

**[Table 5]**

| Lower layer formation type | | Tool body symbol | Metal ion bombardment process conditions | | | | | | |
|---|---|---|---|---|---|---|---|---|---|
| | | | Bombardment metal type | Temperature of tool body during bombardment process (°C) | Furnace inner atmosphere | Furnace inner pressure (Pa) | Bias voltage to tool body (V) | Arc current (A) | Bombardment process time (min) |
| Comparative example conditions | 1 | 1 | Ti | 760 | Vacuum atmosphere | 7×10⁻⁴ | -1000 | 100 | 30 |
| | 2 | 2 | Ti | 770 | Vacuum atmosphere | 8×10⁻⁴ | -1000 | 100 | 45 |
| | 3 | 3 | Ti | 790 | Vacuum atmosphere | 5×10⁻⁴ | -1000 | 100 | 60 |
| | 4 | 4 | Ti | 780 | Vacuum atmosphere | 1×10⁻⁴ | -1000 | 100 | 35 |
| | 5 | 1 | Ti | 800 | Vacuum atmosphere | 8×10⁻³ | -800 | 120 | 4 |
| | 6 | 2 | Ti | 840 | H₂+Ar | 0.08 | -1000 | 120 | 10 |

**[Table 6]**

| Type | | Tool body symbol | Lower layer formation type | Formation conditions of A layer | | | Formation conditions of B layer | | |
|---|---|---|---|---|---|---|---|---|---|
| | | | | Temperature of tool body (°C) | Nitrogen partial pressure (Pa) | Bias voltage (-V) | Temperature of tool body (°C) | Nitrogen partial pressure (Pa) | Bias voltage (-V) |
| Comparative example conditions | 1 | 1 | 1 | 500 | 4.0 | -50 | 500 | 4.0 | -75 |
| | 2 | 2 | 2 | 500 | 4.0 | -50 | 500 | 4.0 | -150 |
| | 3 | 3 | 3 | 500 | 6.7 | -75 | 500 | 6.7 | -100 |
| | 4 | 4 | 4 | 500 | 4.0 | -30 | 500 | 6.7 | -50 |
| | 5 | 1 | 5 | 500 | 4.0 | -50 | 500 | 4.0 | -50 |
| | 6 | 2 | 6 | 500 | 4.0 | -40 | 500 | 4.0 | -100 |

**[Table 7]**

| Type | | Condition type of comparative example | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Comparative example tools | 1 | 1 | 80 | TiC | 60 | Ti(C,N) | 20 | *0.05 | 0.60 | 4.0 | 0.07 | *0.43 | 0.04 | *0.12 | 4.1 |
| | 2 | 2 | 220 | TiC | 130 | Ti(C,N) | 60 | 3.0 | 0.55 | *5.2 | 0.20 | 0.20 | 0.03 | 0.07 | *8.2 |
| | 3 | 3 | 470 | TiC | 280 | Ti(C,N) | 160 | 0.2 | *0.72 | 0.2 | 0.40 | 0.05 | 0.15 | 0.05 | *0.8 |
| | 4 | 4 | 180 | TiC | 140 | Ti(C,N) | 30 | *5.2 | *0.38 | 2.0 | 0.10 | 0.30 | 0.05 | 0.01 | 7.2 |
| | 5 | 5 | *3 | TiC | 5 | - | - | 3.3 | 0.50 | 1.1 | 0.15 | *0.03 | *0.22 | 0.03 | 4.4 |
| | 6 | 6 | 60 | TiC | 90 | - | - | 0.5 | 0.45 | 0.5 | *0.42 | 0.10 | 0.10 | *0.005 | 5.0 |

| | | | | | | | | | | | | | | | |
|---|---|---|---|---|---|---|---|---|---|---|---|---|---|---|---|
| A value with * indicates a value not satisfying the claims of the present application. | | | | | | | | | | | | | | | |

Next, in a state in which each of the tools 1 to 8 of the present invention and the comparative example tools 1 to 6 was clamped to a tip portion of an insert holder of tool steel with a fixing jig, the tools were subjected to wet continuous cutting test of Ni-based heat resistant alloy under the following conditions (referred to as cutting conditions 1), and the wear width of flank face of a cutting edge was measured.

### <Cutting conditions 1>

Work Material: a round bar of Ni-based heat resistant alloy (Cr 19 mass%-Fe 19 mass%-Mo 3 mass%-Ti 0.9 mass%-Al 0.5 mass%-Ni balance)
Cutting speed: 100 m/min
Cutting depth: 0.5 mm
Feed: 0.15 mm/rev.
Cutting time: 10 minutes
Cutting fluid: water-soluble coolant

Table 8 shows the results thereof.

**[Table 8]**

| Type | | Cutting condition 1 | Type | | Cutting condition 1 |
|---|---|---|---|---|---|
| | | Wear width of flank face (mm) | | | Wear width of flank face (mm) |
| Tool of present invention | 1 | 0.10 | Comparative example tool | 1 | 0.25 |
| | 2 | 0.08 | | 2 | 0.27 |
| | 3 | 0.12 | | 3 | 0.31 |
| | 4 | 0.07 | | 4 | 0.30 |
| | 5 | 0.16 | | 5 | *3 |
| | 6 | 0.14 | | 6 | *7 |
| | 7 | 0.13 | | | |
| | 8 | 0.15 | | | |

(In the table, a value with * in the column of the comparative example indicates cutting time (min) until the service life ends due to a reason such as peeling, adhesion, chipping, wear or the like.)

### <<Example 2>>

Raw material powders having the blending composition shown in Table 1 were sintered under the conditions shown in Example 1 to form a round bar sintered body for forming a tool body having a diameter of 10 mm. In the grinding process, tool bodies 11 (end mill) 1 to 4 made of WC-based cemented carbide having 4-flute square shape with a helix angle of 30 degrees were manufactured respectively to have a dimension of diameter × length of the cutting edge portion as 6 mm × 12 mm, from the round bar sintered body.

Next, for the above-mentioned tool bodies 11 (end mills) 1 to 4, the surface-coated end mills 11 to 18 of the present invention (hereinafter, referred to as tools 11 to 18 of the present invention) shown in Table 9 were manufactured in the steps same as the steps (a) to (e) of Example 1 using the AIP apparatus 10.

For the tools 11 to 18 of the present invention manufactured as above, the W layer, the metal carbide layer, and the metal carbonitride layer of the lower layer were identified and each layer thickness was calculated by the same method as in Example 1. The average composition and average layer thickness of each component were also calculated for the A layer and the B layer of the upper layer.

Table 9 shows the measured and calculated values.

**[Table 9]**

| Type | | Conditions of present invention | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per on layer (µm) | x value | Average layer thickness per one layer (µm) | a value | b value | c value | d value | |
| Tool of present invention | 11 | 1 | 180 | TiC | 110 | (Al,Ti)(C,N) | 60 | 3.8 | 0.49 | 1.0 | 0.17 | 0.24 | 0.08 | 0.03 | 4.8 |
| | 12 | 2 | 170 | TiC | 140 | Ti(C,N) | 30 | 2.0 | 0.58 | 2.1 | 0.25 | 0.18 | 0.05 | 0.02 | 4.1 |
| | 13 | 3 | 12 | Cr₃C₂ | 8 | Cr(C,N) | 5 | 4.7 | 0.40 | 1.2 | 0.30 | 0.09 | 0.10 | 0.10 | 5.9 |
| | 14 | 4 | 80 | TiC | 70 | Ti(C,N) | 20 | 0.9 | 0.59 | 4.1 | 0.21 | 0.20 | 0.03 | 0.02 | 5.0 |
| | 15 | 5 | 450 | ZrC | 400 | Zr(C,N) | 40 | 0.1 | 0.66 | 0.1 | 0.05 | 0.38 | 0 | 0.04 | 1.0 |
| | 16 | 6 | 330 | NbC | 70 | Nb(C,N) | 250 | 0.3 | 0.41 | 0.3 | 0.39 | 0.05 | 0.15 | 0.05 | 2.4 |
| | 17 | 7 | 320 | TaC | 250 | Ta(C,N) | 60 | 0.2 | 0.58 | 0.3 | 0.10 | 0.22 | 0.19 | 0.01 | 1.5 |
| | 18 | 8 | 360 | HfC | 220 | Hf(C,N) | 120 | 3.1 | 0.50 | 4.9 | 0 | 0.31 | 0.12 | 0.07 | 8.0 |

Next, the end mills of the tools 11 to 18 of the present invention were subjected to a shoulder cutting test of a Ni-based heat resistant alloy under the following conditions (referred to as cutting conditions 2) to measure the wear width of flank face of the cutting edge.

### <Cutting conditions 2>

Work Material-flat surface dimension: a plate material of Ni-based heat resistant alloy having a plane dimensions of 100 mm × 250 mm and a thickness of 50 mm (Cr 19 mass%-Fe 19 mass%-Mo 3 mass%-Ti 0.9 mass%-Al 0.5 mass%-Ni balance)
Cutting speed: 40 m/min
Rotation rate: 2,100 min.⁻¹
Cutting depth: ae 0.3 mm, ap 6 mm
Feed rate (per tooth): 0.03 mm/tooth
Cutting length: 10 m

Table 10 shows cutting test results.

**[Table 10]**

| Type | | Cutting condition 2 |
|---|---|---|
| | | Wear width of flank face (mm) |
| Tool of present invention | 11 | 0.10 |
| | 12 | 0.09 |
| | 13 | 0.15 |
| | 14 | 0.08 |
| | 15 | 0.14 |
| | 16 | 0.13 |
| | 17 | 0.12 |
| | 18 | 0.14 |

### <<Example 3>>

Using a round bar sintered body having a diameter of 10 mm manufactured in Example 2 above, in the grinding process, tool body 11 (drill) made of WC-based cemented carbide having 2-flute blade shape with a helix angle of 30 degrees was manufactured to have a dimension of diameter × length of a groove forming portion as 6 mm × 30 mm, from the round bar sintered body.

Next, the cutting edge of this tool body 11 (drill) was subjected to honing, ultrasonic cleaning in acetone, and then dried.

Next, the resultant was loaded on the AIP apparatus 10, and surface-coated drills 21 to 28 of the present invention (hereinafter, referred to as tools 21 to 28 of the present invention) including the lower layer and the upper layer shown in Table 11 were manufactured under the same conditions as in Example 1.

For the tools 21 to 28 of the present invention manufactured as above, the W layer 4, the metal carbide layer 5, and the metal carbonitride layer 6 of the lower layer were identified and each layer thickness was calculated by the same method as in Example 1. The average composition of each component and average layer thickness were also calculated for the A layer and the B layer of the upper layer.

Table 11 shows the measured and calculated values.

**[Table 11]**

| Type | | Condition type of present invention | Lower layer | | | | | Upper layer | | | | | | | |
|---|---|---|---|---|---|---|---|---|---|---|---|---|---|---|---|
| | | | Average depth of W layer (nm) | Metal carbide layer | | Metal carbonitride layer | | A layer | | B layer | | | | | Average total layer thickness of upper layer (µm) |
| | | | | Type | Average layer thickness (nm) | Type | Average layer thickness (nm) | Average layer thickness per one layer (µm) | x value | Average layer thickness per one layer (µm) | a value | b value | c value | d value | |
| Tool of present invention | 21 | 1 | 210 | TiC | 130 | (Al,Ti)(C,N) | 70 | 3.9 | 0.50 | 1.0 | 0.17 | 0.26 | 0.08 | 0.03 | 4.9 |
| | 22 | 2 | 180 | TiC | 150 | Ti(C,N) | 30 | 1.8 | 0.60 | 1.9 | 0.24 | 0.19 | 0.05 | 0.02 | 3.7 |
| | 23 | 3 | 10 | Cr₃C₂ | 7 | Cr(C,N) | 5 | 4.8 | 0.40 | 1.3 | 0.28 | 0.10 | 0.10 | 0.09 | 6.1 |
| | 24 | 4 | 70 | TiC | 50 | Ti(C,N) | 20 | 1.0 | 0.60 | 4.0 | 0.19 | 0.20 | 0.03 | 0.02 | 5.0 |
| | 25 | 5 | 480 | ZrC | 410 | Zr(C,N) | 60 | 0.1 | 0.70 | 0.1 | 0.05 | 0.40 | 0 | 0.04 | 1.0 |
| | 26 | 6 | 320 | NbC | 70 | Nb(C,N) | 240 | 0.3 | 0.40 | 0.3 | 0.40 | 0.05 | 0.14 | 0.05 | 2.4 |
| | 27 | 7 | 280 | TaC | 220 | Ta(C,N) | 50 | 0.2 | 0.60 | 0.3 | 0.10 | 0.23 | 0.20 | 0.01 | 1.5 |
| | 28 | 8 | 360 | HfC | 230 | Hf(C,N) | 130 | 2.9 | 0.50 | 4.9 | 0 | 0.29 | 0.12 | 0.07 | 7.8 |

Next, the tools 21 to 28 of the present invention were subjected to a wet drilling cutting test a Ni-based heat resistant alloy under the following conditions (referred to as cutting conditions 3) to measure the wear width of flank face of the cutting edge, in a case where the number of holes was set to 30.

### <Cutting conditions 3>

Work Material-flat surface dimension: a plate material of Ni-based heat resistant alloy having a plane dimensions of 100 mm × 250 mm and a thickness of 50 mm (Cr 19 mass%-Fe 19 mass%-Mo 3 mass%-Ti 0.9 mass%-Al 0.5 mass%-Ni balance)
Cutting speed: 13.7 m/min
Feed: 0.06 mm/rev.
Hole depth: 12 mm

Table 12 shows cutting test results.

**[Table 12]**

| Type | | Cutting condition 3 |
|---|---|---|
| | | Wear width of flank face (mm) |
| Tool of present invention | 21 | 0.10 |
| | 22 | 0.08 |
| | 23 | 0.14 |
| | 24 | 0.08 |
| | 25 | 0.15 |
| | 26 | 0.14 |
| | 27 | 0.13 |
| | 28 | 0.12 |

From the results shown in Table 8, Table 10, and Table 12, it is found that the tools of the present invention 1 to 8, 11 to 18, and 21 to 28 prevent the occurrence of peeling, prevent the occurrence of abnormal damage such as adhesion, chipping, and fracture, during high-speed cutting of a Ni-based heat resistant alloy, in which high-temperature heat is generated and great thermal loads and mechanical loads are exerted to a cutting edge, and exhibit excellent wear resistance during long-term use.

On the other hand, in the comparative example tools 1 to 6, peeling, chipping, fracture, and the like occurred due to thermal loads and mechanical loads exerted to the cutting edge during the cutting, and had a short life.

### [Industrial Applicability]

The coated tool of the present invention prevents the occurrence of peeling and prevents the occurrence of abnormal damage such as adhesion, chipping, and fracture, during high-speed cutting of a Ni-based heat resistant alloy, in which high-temperature heat is generated and great thermal loads and mechanical loads are exerted to a cutting edge, and exhibits excellent cutting performance during long-term use.

### [Reference Signs List]

- 2: Lower layer
- 3: upper layer
- 4 W: layer (tungsten layer)
- 5: Metal carbide layer
- 6: Metal carbonitride layer
- 10: AIP apparatus (Arc ion plating apparatus)
- 11: tool body
- 12: rotation table
- 13: Al-Ti alloy target (evaporation source)
- 14: Al-Ti-Cr-Si-Y alloy target (evaporation source)
- 15, 16: Anode electrode
- 17, 18: arc electric power supply
- 19: Bias electric power supply
- 20: Reaction gas inlet
- 21: Exhaust gas outlet

## Claims

1. A surface-coated cutting tool comprising:
a tool body formed of a tungsten carbide-based cemented carbide;
a lower layer provided on the tool body; and
an upper layer provided on a surface of the lower layer and having an alternately laminated structure,
wherein (a) the lower layer consists of a W layer, a metal carbide layer, and a metal carbonitride layer,
(b) the W layer is formed from a surface of the tool body to an inside thereof over a depth of 10 to 500 nm,
(c) the metal carbide layer, a metal of which is any one selected from Ti, Cr, Zr, Hf, Nb, and Ta, has an average layer thickness of 5 to 500 nm, and is formed directly on the W layer,
(d) the metal carbonitride layer includes a metal component contained in the metal carbide layer, has an average layer thickness of 5 to 300 nm, and is formed directly on the metal carbide layer,
(e) the upper layer has an alternately laminated structure in which at least one A layer and at least one B layer are alternately laminated and has an average total layer thickness of 1.0 to 8.0 µm,
(f) the A layer is a composite nitride layer of Al and Ti having a one-layer average layer thickness of 0.1 to 5.0 µm and has an average composition satisfying 0.40 ≤ x ≤ 0.70 (where x is an atomic ratio), in a case where a composition of the composite nitride layer is represented by a composition formula: (AlₓTi₁₋ₓ)N, and
(g) the B layer is a composite nitride layer of Al, Ti, Cr, Si, and Y having a one-layer average layer thickness of 0.1 to 5.0 µm and has an average composition satisfying 0 ≤ a ≤ 0.40, 0.05 ≤ b ≤ 0.40, 0 ≤ c ≤ 0.20, and 0.01 ≤ d ≤ 0.10 (where, all of a, b, c, and d are atomic ratios), in a case where a composition of the composite nitride layer is represented by a composition formula: (Al_{1-a-b-c-d}TiₐCr_{b}Si_{c}Y_{d})N.

2. The surface-coated cutting tool according to claim 1,
wherein the surface-coated cutting tool is any one of a surface-coated insert, a surface-coated end mill, and a surface-coated drill.

3. A surface-coated cutting tool for high-speed cutting of an Ni-based heat resistant alloy, which is formed of the surface-coated cutting tool according to claim 1 or 2.
